# EUROPÄISCHE PATENTSCHRIFT

(11) **EP 4 046 339 B1**
(45) Veröffentlichungstag und Bekanntmachung des Hinweises auf die Patenterteilung: **11.01.2023**
(21) Anmeldenummer: 20792648.6
(22) Anmeldetag: 16.10.2020
(51) Int. Cl.: H04L 12/423

(54) **SICHERE PRÜFANORDNUNG**
SAFE TEST ARRANGEMENT
AGENCEMENT D'ESSAI SÛR

(30) Priorität: 18.10.2019 AT 508982019
(43) Veröffentlichungstag der Anmeldung: 24.08.2022
(73) Patentinhaber: Omicron electronics GmbH, 6833 Klaus (AT)
(72) Erfinder: NUSSBAUMER, Roland, 6850 Dornbirn (AT); BLOCHER, Thomas, 6800 Feldkirch (AT); KUKUK, Matthias, 6923 Lauterach (AT)
(74) Vertreter: Patentanwälte Pinter & Weiss OG
(86) Internationale Anmeldenummer: PCT/EP2020/079201
(87) Internationale Veröffentlichungsnummer: WO 2021/074373

(56) Entgegenhaltungen:
- EP-A1- 3 151 476
- WO-A1-2016/055307
- DE-A1-102017 130 167
- DE-A1-102017 209 309

## Beschreibung

Die gegenständliche Erfindung betrifft ein Verfahren zum Betrieb einer Prüfanordnung umfassend eine Mehrzahl Sicherheitskomponenten, wobei die Sicherheitskomponenten jeweils einen Signaleingang zum Empfang von Datenpaketen und einen Signalausgang zum Versand von Datenpaketen aufweisen, wobei an den Sicherheitskomponenten jeweils ein aktiv oder inaktiv setzbares Sicherheitsmodul und ein aktiv oder inaktiv setzbarer Bereitschaftsstatus vorgesehen ist, wobei das Sicherheitsmodul einer Sicherheitskomponente bei einem inaktivem Bereitschaftsstatus der zugehörigen Sicherheitskomponente inaktiv gesetzt wird.

Ein Prüfgerät kann verwendet werden, um an gefährlichen Prüfobjekten, wie beispielsweise Stromwandlern, Messungen durchzuführen. Da ein gefährliches Prüfobjekt eine gefährliche Menge an Energie speichern kann, sind bei der Durchführung von Messungen ausreichende Sicherheitsvorkehrungen zu treffen. Aus diesem Grund kann das Prüfgerät durch weitere Komponenten auf eine Prüfanordnung erweitert werden. Beispielsweise kann ein gefährlicher Arbeitsbereich mit Warnlampen und Notaus-Schaltern als Komponenten versehen werden. Notausschalter können eine rasche und sichere Abschaltung von Strom- und Spannungsverstärker im Prüfgerät ermöglichen. Warnlampen hingegen können beispielsweise anzeigen, ob das Prüfobjekt bzw. der Arbeitsbereich sicher (entladen) oder unsicher (stromführend) ist. Als weitere Komponente kann eine Einschaltsicherung des Prüfgeräts vorgesehen sein, um ein unbefugtes Einschalten zu verhindern. Eine Aktivierung einer Einschaltsicherung kann insbesondere bei Arbeiten an der Verkabelung einen wichtigen Sicherheitsaspekt darstellen. Eine Prüfanordnung umfasst meist eine Mehrzahl an Komponenten, umfassend Prüfgeräte, Warnlampen, Notausschalter, Einschaltsicherungen, etc.

Eine Möglichkeit eine derartige Prüfanordnung aufzubauen, ist die Verwendung eines Sicherheitskreises mit diskreten Signalen. Dabei sind die Komponenten der Prüfanordnung über einen Sicherheitsfeldbus miteinander verbunden, wobei eine Kommunikation der Komponenten über sicher ausgeführte Signale erfolgt. Daher werden Sicherheitsfeldbusse vom Hersteller konfiguriert und getestet. Der Anwender kann und darf den Sicherheitsfeldbus aus Sicherheitsgründen nicht verändern. Aus diesem Grund ist es für den Anwender nicht möglich weitere Komponenten in die Prüfanordnung einzubinden oder zusätzliche Informationen, z.B. für Diagnosezwecke, zu übertragen. Daher ist es neben hohen Sicherheitsstandards hinsichtlich der Kommunikation zwischen den Komponenten auch wünschenswert, dass alle Komponenten eine hohe Lebensdauer aufweisen. Da die Komponenten fest miteinander verbunden sind, tritt ein hoher Aufwand für bei der Verkabelung auf. Weiters ist ein Erkennen und Vermeiden von Fehlern in der Verkabelung (Kabelbruch, Kurzschluss, Übersprechen, etc.) sehr aufwändig. Diese Probleme sind im Stand der Technik bekannt. So beschreibt die DE 10 2017 130167 A1 ein Verfahren zur Ausfallerkennung von Netzwerkverbindungen, wobei der Fokus auf eine sichere Übermittlung von Testdaten über diese Netzwerkverbindungen gelegt wird. In der DE 10 2017 130167 A1 wird, wie im Stand der Technik generell, jedoch nur beschränkt auf die Netzwerkteilnehmer bzw. Komponenten selbst und auf deren individuelle Überprüfung eingegangen.

Es ist daher eine Aufgabe der gegenständlichen Erfindung eine flexible Prüfanordnung zur Durchführung von Messungen an einem Prüfobjekt anzugeben.

Diese Aufgabe wird erfindungsgemäß gelöst, indem die Signaleingänge und Signalausgänge der Sicherheitskomponenten derart verbunden werden, dass die Sicherheitskomponenten eine ringförmige Prüfanordnung mit einer Übertragungsrichtung für die Datenpakete bilden, wobei die Sicherheitskomponenten jeweils zyklisch eine Anzahl an Funktionstest durchführen, und ihren Bereitschaftsstatus bei Erfolg der Anzahl an Funktionstests auf aktiv und bei Fehlschlagen zumindest eines der Funktionstests auf inaktiv setzen, wobei als einer der Funktionstests ein zyklischer fehlerfreier Empfang eines Datenpakets geprüft wird. Es wird eine der Sicherheitskomponenten als Busmaster ausgewählt, welcher zyklisch ein Busüberprüfungssignal in einem Datenpaket an die nächste in Übertragungsrichtung vorgesehene Sicherheitskomponente sendet, wobei das Busüberprüfungssignal jeweils von den Sicherheitskomponenten in einem Datenpaket weitergeleitet wird, wobei der Busmaster bei einem Empfang des Busüberprüfungssignals in einem Datenpaket eine geschlossene ringförmige Prüfanordnung feststellt.

Die ringförmige Prüfanordnung bildet somit einen Ringbus, welcher die Sicherheitskomponenten umfasst. Dabei sind die Signalausgänge der Sicherheitskomponenten jeweils mit den Signaleingängen der weiteren Sicherheitskomponenten ringförmig verbunden, womit die Prüfanordnung genau eine Übertragungsrichtung für die Übertragung von Datenpaketen aufweist. Um zu prüfen, ob die ringförmige Prüfanordnung geschlossen ist, wird eine der Sicherheitskomponenten als Busmaster bestimmt. Der Busmaster schickt zyklisch in einem Datenpaket ein Busüberprüfungssignal über die Sicherheitskomponenten der Prüfanordnung, wobei die einzelnen Sicherheitskomponenten das Busüberprüfungssignal jeweils in einem Datenpaket weiterleiten. Kommt das Busüberprüfungssignal wieder beim Busmaster an, so kann dieser eine geschlossene Prüfanordnung feststellen. Als Zyklusdauer für den Versand von Datenpaketen sind vorzugsweise 10 ms bis 100 ms vorgesehen, wobei geringere Zyklusdauern die Reaktionszeit verbessern, insbesondere für den Fall eines fehlgeschlagenen Funktionstests.

Ob die jeweilige Sicherheitskomponente tatsächlich einen aktiven Bereitschaftsstatus aufweist, hängt vom Typ der Sicherheitskomponente und den entsprechenden Funktionstests ab.

Die Übertragung der Datenpakete zwischen den Sicherheitskomponenten selbst muss im Gegensatz zu Sicherheitsbussen nach dem Stand der Technik nicht sicher sein. Stattdessen führen die Sicherheitskomponenten eine Anzahl an Funktionstests durch, wobei zumindest ein essentieller Funktionstest in Form einer Prüfung eines zyklischen fehlerfreien Empfangs eines Datenpakets stattfindet. Neben diesem Funktionstest können weitere Funktionstests durchgeführt werden. Nur wenn alle Funktionstest erfolgreich sind, wird der Bereitschaftsstatus der jeweiligen Sicherheitskomponente auf aktiv gesetzt. Schlägt einer oder mehrere der Funktionstests fehl, so wird der Bereitschaftsstatus der Sicherheitskomponente auf inaktiv gesetzt. Eine derartige Kommunikationsverbindung zwischen den Sicherheitskomponenten wird als sogenannter "Blackchannel" bezeichnet, was bedeutet, dass die Kommunikation zwischen den Sicherheitskomponenten funktional nicht als sicher betrachtet wird.

Vorzugsweise prüft der Busmaster bei Feststellung einer geschlossenen ringförmigen Prüfanordnung zyklisch, ob sein Bereitschaftsstatus aktiv ist und sendet bei einem aktiven Bereitschaftsstatus ein Bereitschaftssignal in einem Datenpaket an die nächste in Übertragungsrichtung befindliche Sicherheitskomponente, wobei die Sicherheitskomponenten jeweils bei Empfang des Bereitschaftssignals prüfen ob ihr Bereitschaftsstatus aktiv ist und bei einem aktivem Bereitschaftsstatus ein Bereitschaftssignal in einem Datenpaket an die nächste in Übertragungsrichtung vorgesehene Sicherheitskomponente senden.

Stellt der Busmaster also durch den Empfang des Busüberprüfungssignals eine geschlossene ringförmige Prüfanordnung fest und ist sein Bereitschaftsstatus aktiv, so sendet der Busmaster ein Bereitschaftssignal an die nächste in Übertragungsrichtung angeordnete Sicherheitskomponente, d.h. an die Sicherheitskomponente, deren Signaleingang mit dem Signalausgang des Busmasters verbunden ist. Diese Sicherheitskomponente empfängt das Bereitschaftssignal und prüft ihren eigenen Bereitschaftsstatus. Ist ihr Bereitschaftsstatus aktiv, so sendet diese Sicherheitskomponente das Bereitschaftssignal in einem Datenpaket an die wiederum nächste in Übertragungsrichtung angeordnete Sicherheitskomponente, etc. Im Gegensatz zum Busüberprüfungssignal wird das Bereitschaftssignal also nicht zwingend in den jeweiligen Datenpaketen bis zum Busmaster weitergeleitet, wenn die ringförmige Prüfanordnung geschlossen ist, sondern nur wenn alle Sicherheitskomponenten auch tatsächlich einen aktiven Bereitschaftsstatus aufweisen.

Vorzugsweise stellt der Busmaster bei Empfang des Bereitschaftssignals eine betriebsbereite Prüfanordnung fest und sendet ein Aktiviersignal in einem Datenpaket an die nächste in Übertragungsrichtung vorgesehene Sicherheitskomponente, wobei die Sicherheitskomponenten jeweils bei Empfang eines Aktiviersignals ihr Sicherheitsmodul aktivieren und das Aktiviersignal in einem Datenpaket weiterleiteten.

Sind alle Sicherheitsmodule aktiv, so ist die Prüfanordnung aktiviert und es können durch die Sicherheitskomponenten sicherheitsrelevante Information ausgetauscht werden. Eine sicherheitsrelevante Information stellt eine Information dar, welche für die Ausführung der Messung im Prüfaufbau erforderlich ist, dar.

Die Prüfanordnung bietet somit nur einen funktional sicheren Kommunikationskanal zum Versand und Empfang von sicherheitsrelevanten Informationen, wenn alle Sicherheitskomponenten ein aktiviertes Sicherheitsmodul aufweisen. Ist dem der Fall, so kann als sicherheitsrelevante Informationen zwischen den Sicherheitskomponenten auch eine Zusammenfassung aller Sicherheitskomponenten in der Prüfanordnung vorgesehen sein.

Die Sicherheitskomponenten können beispielsweise Ausgabeeinheiten zum Ausgeben von sicherheitsrelevanter Information, Eingabeeinheiten zum Eingeben von sicherheitsrelevanter Information, Leistungseinheiten zur Ein/Ausgabe von sicherheitsrelevanter Information, etc. umfassen. Eine Sicherheitskomponente kann jedoch nur sicherheitsrelevante Information aus Datenpaketen auslesen und/oder in Datenpakete schreiben, wenn ein Sicherheitsmodul einer Sicherheitskomponente aktiv ist.

Als Eingabeeinheiten können beispielsweise Freigabeeinheiten zur Freigabe der Prüfanordnung, bzw. Schlüsselschalter zum Sichern der Prüfanordnung gegen Unbefugte, vorgesehen sein können. Ebenso können als Eingabeeinheiten Sperreinheiten, wie beispielsweise Notausschalter, zum Deaktivieren einzelner oder aller Sicherheitskomponenten, bzw. deren Funktionen vorgesehen sein. Ebenso können Startschalter zur finalen Freigabe der Messung durch die Prüfanordnung vorgesehen sein.

Als Leistungseinheiten können, z.B. Stromverstärker, Spannungsverstärker, "Switchboxen", welche gefährliche Spannungen/Ströme abschalten, etc. in Sicherheitskomponenten vorgesehen sein. Bei einem inaktiven Sicherheitsmodul muss dabei sichergestellt werden, dass die Leistungseinheiten ausgeschaltet sind.

Als Ausgabeeinheiten können beispielsweise Warnlampen oder Anzeigeeinheiten von Messwerten vorgesehen sein, wobei beispielsweise bei einer aktiven Leistungseinheit eine Warnfarbe (beispielsweise rot) und bei einer stromfreien Leistungseinheit eine Bereitschaftsfarbe (beispielsweise Grün) angezeigt werden kann.

Eine Sicherheitskomponente kann eine oder mehrere Ausgabeeinheiten, Eingabeeinheiten, Leistungseinheiten oder eine Kombination davon umfassen.

Es kann beispielsweise aufgrund empfangener sicherheitsrelevanter Information in einem Datenpaket eine Sicherheitskomponente einen Notaus auslösen. Dieser Notaus wird wieder als sicherheitsrelevante Information in einem Datenpaket verschickt, wobei eine weitere Sicherheitskomponente diese sicherheitsrelevante Information ausliest und ein Warnlicht anzeigt. Wieder eine weitere Sicherheitskomponente kann beispielsweise ihre Leistungseinheit deaktivieren. Es kann als sicherheitsrelevante Information auch ein gefährlicher Zustand einer Leistungseinheit einer Sicherheitskomponente als Datenpaket versendet werden und wiederum ausgelesen und ausgegeben, werden. Als gefährlich kann beispielsweise die Definition von "Hazard" in der Normen IEC 61508, vorzugsweise in der Edition 2.0 oder der Norm ISO 13849, vorzugsweise in der Version ISO 13849-1:2015, ISO 13849-2:2012, angesehen werden.

Vorzugsweise sendet der Busmaster nach dem Versand eines Bereitschaftssignals und bei Nicht-Empfang eines Bereitschaftssignals ein Notaussignal in einem Datenpaket an die nächste in Übertragungsrichtung vorgesehene Sicherheitskomponente, wobei die Sicherheitskomponenten jeweils bei Empfang des Notaussignals ihr Sicherheitsmodul deaktivieren und das Notaussignal in einem Datenpaket weiterleiten. Erhält der Busmaster sein Bereitschaftssignal nicht innerhalb des geplanten Zyklus zurück, so schließt er darauf, dass zumindest eine Sicherheitskomponente einen inaktiven Bereitschaftszustand aufweist. Ein darauffolgender Versand eines Notaussignals kann sicherstellen, dass auch alle Sicherheitsmodule aller Sicherheitskomponenten inaktiv sind.

Vorzugsweise sendet der Busmaster nach dem Versand eines Busüberprüfungssignals und bei Nicht-Empfang eines Busüberprüfungssignals ein Notaussignal in einem Datenpaket an die nächste in Übertragungsrichtung vorgesehene Sicherheitskomponente, wobei die Sicherheitskomponenten jeweils bei Empfang des Notaussignals ihr Sicherheitsmodul deaktivieren und das Notaussignal in einem Datenpaket weiterleiten. Damit kann insbesondere bei einem Ringbruch und einer Konfiguration der Sicherheitskomponenten, bei welcher sie immer ein Datenpaket absenden, selbst wenn sie kein Datenpaket empfangen, sichergestellt werden, auch tatsächlich alle Sicherheitsmodule deaktiviert werden.

Vorzugsweise führen die Sicherheitskomponenten einen Sicherheitstest durch und deaktivieren bei Fehlschlagen des Sicherheitstest ihren Bereitschaftsstatus und senden ein Notaussignal in einem Datenpaket an die nächste in Übertragungsrichtung vorgesehene Sicherheitskomponente, wobei die Sicherheitskomponenten bei Empfang des Notaussignals ihr Sicherheitsmodul deaktivieren und das Notaussignal in einem Datenpaket versenden. Während des Sicherheitstests werden Funktionen der Sicherheitskomponenten, die sicherheitskritisch sind, geprüft. Bei Fehlschlagen des Sicherheitstests wird also sofort der Bereitschaftsstatus und damit auch das Sicherheitsmoduls deaktiviert und auch sofort ein Datenpaket mit einem Notaussignal abgesendet, um alle weiteren Sicherheitsmodule aller weiteren Sicherheitskomponenten möglichst rasch zu deaktivieren.

Vorzugsweise erfolgt die Auswahl des Busmasters über eine Komponentenidentifikation der Sicherheitskomponenten. Vorzugsweise wird die Sicherheitskomponente mit der niedrigsten Komponentenidentifikationen als Busmaster ausgewählt.

Die Sicherheitskomponenten können eine Komponentenidentifikation mit dem Busüberprüfungssignal im Datenpaket senden, wobei der Busmaster die Sicherheitskomponenten durch die mit dem Busüberprüfungssignal empfangenen Komponentenidentifikationen identifiziert.

Vorzugsweise versendet der Busmaster die Komponentenidentifikationen in einem Datenpaket wieder an die jeweilige Sicherheitskomponenten zurück, wobei eine Sicherheitskomponente ihren Bereitschaftsstatus auf inaktiv setzt, wenn sie ihre Identifikation nicht vom Busmaster zurück empfängt.

Das Busüberprüfungssignal, das Bereitschaftssignal, das Aktiviersignal, Notaussignal, etc. kann vom Busmaster im selben Datenpaket oder ein einzelnen Datenpaketen versendet werden. Werden Busüberprüfungssignal und Bereitschaftssignal in einem Datenpaket versendet, dann kann bei Empfang des Bereitschaftssignals im Datenpaket durch den Busmaster festgestellt werden, dass die ringförmige Prüfanordnung weiterhin geschlossen ist. Nur wenn das Datenpaket beim Empfang durch Busmaster auch ein Bereitschaftssignal beinhaltet, kann der Busmaster auch feststellen, dass alle Sicherheitskomponenten einen aktiven Bereitschaftsstatus aufweisen.

Sind die Sicherheitsmodule aktiv, so können auch die sicherheitsrelevanten Informationen über dasselbe Datenpaket, wie das Busüberprüfungssignal, das Bereitschaftssignal, das Aktiviersignal, Notaussignal, etc. gesendet werden.

Die gegenständliche Erfindung wird nachfolgend unter Bezugnahme auf die Figuren 1 bis 6 näher erläutert, die beispielhaft, schematisch und nicht einschränkend vorteilhafte Ausgestaltungen der Erfindung zeigen. Dabei zeigt
- Fig.1: eine Sicherheitskomponente,
- Fig.2: eine Prüfanordnung umfassend drei Sicherheitskomponenten,
- Fig.3: einen Versand eines Busüberprüfungssignals,
- Fig.4a: einen Versand eines Bereitschaftssignals, wobei eine Sicherheitskomponenten einen inaktiven Bereitschaftsstatus aufweist,
- Fig.4b: einen Versand eines Bereitschaftssignals, wobei alle Sicherheitskomponenten einen aktiven Bereitschaftsstatus aufweisen,
- Fig.5: einen Versand eines Aktiviersignals,
- Fig.6a: einen Ringbruch,
- Fig.6b: einen Versand eines Notaussignals.

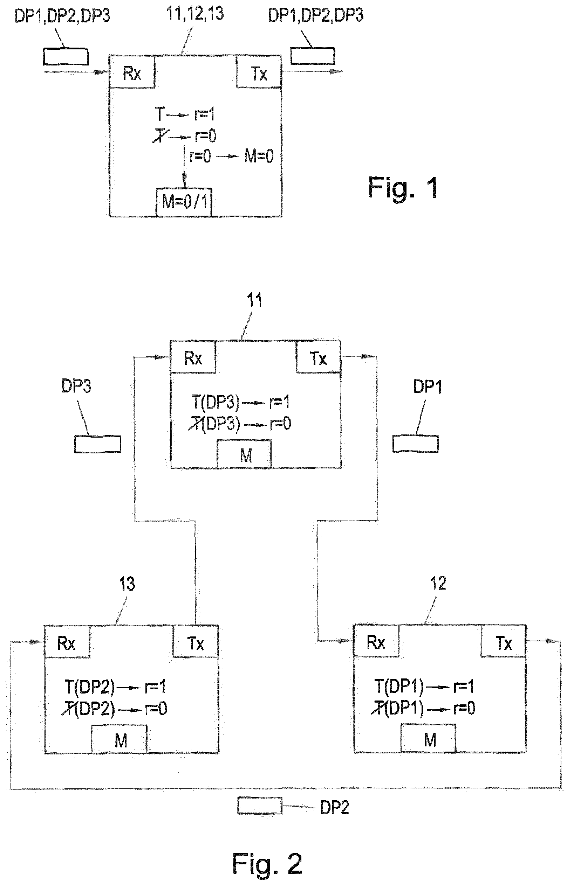

In Fig. 1 ist eine Sicherheitskomponente 11, 12, 13 dargestellt. Die Sicherheitskomponente 11, 12, 13 weist einen Signaleingang Rx, zum Empfang von Datenpaketen DP1, DP2, DP3 und einen Signalausgang Tx, zum Versand von Datenpaketen DP1, DP2, DP3, auf. Die Sicherheitskomponente 11, 12, 13 weist weiters einen Bereitschaftsstatus r auf, welcher aktiv oder inaktiv gesetzt sein kann. Die Sicherheitskomponente 11, 12, 13 umfasst ein Sicherheitsmodul M, welches aktiv oder inaktiv gesetzt sein kann, jedoch bei einem inaktiven Bereitschaftsstatus immer inaktiv gesetzt wird. Das bedeutet jedoch nicht, dass das Sicherheitsmodul M bei einem aktiven Bereitschaftsstatus r immer aktiv gesetzt sein muss.

Die Sicherheitskomponente 11, 12, 13 führt zyklisch zumindest einen Funktionstest T durch. Sind alle Funktionstests T erfolgreich so wird der Bereitschaftsstatus r auf aktiv gesetzt. Schlägt nur ein Funktionstest T fehl, so wird der Bereitschaftsstatus r auf inaktiv gesetzt, womit auch das Sicherheitsmodul M inaktiv gesetzt wird bzw. inaktiv bleibt, falls es dies bereits war.

In den dargestellten Figuren ist ein aktiver Bereitschaftsstatus r, wie auch ein aktives Sicherheitsmodul M grundlegend als "1" und ein inaktiver Bereitschaftsstatus r, wie auch ein inaktives Sicherheitsmodul M grundlegend als "0" dargestellt. Ein fehlgeschlagener Funktionstest T wird als durchgestrichenes T dargestellt, ist der Funktionstest T erfolgreich, so wird dieser als T dargestellt.

In Fig. 2 ist ein Aufbau einer Prüfanordnung aus einer Mehrzahl von Sicherheitskomponenten 11, 12, 13, wie sie anhand von Fig. 1 beschrieben werden, dargestellt. Die Sicherheitskomponenten 11, 12, 13 sind als ringförmige Prüfanordnung in Form eines Ringbusses miteinander verbunden, indem je ein Signaleingang Rx einer Sicherheitskomponente 11,12, 13 mit einem Signalausgang Tx einer anderen Sicherheitskomponente 11, 12, 13 verbunden wird. In Fig. 2 ist beispielsweise der Signalausgang Tx der ersten Sicherheitskomponente 11 mit dem Signaleingang Rx der zweiten Sicherheitskomponente 12 verbunden, der Signalausgang Tx der zweiten Sicherheitskomponente 12 mit dem Signaleingang Rx der dritten Sicherheitskomponente 13 und der Signalausgang Tx der dritten Sicherheitskomponente 13 mit dem Signaleingang Rx der ersten Sicherheitskomponente 11.

Natürlich ist in den dargestellten Figuren nur beispielhaft eine Mehrzahl von drei Sicherheitskomponenten 11, 12, 13 gewählt, die Prüfanordnung kann beliebig viele Sicherheitskomponenten 11, 12, 13 umfassen.

Die Sicherheitskomponenten 11, 12, 13 führen als Funktionstests T zumindest eine Prüfung eines zyklischen fehlerfreien Empfangs eines Datenpakets DP durch. Dies kann beispielsweise über einen Prüfsummencheck, eine Sequenzprüfung, ein Timeout, etc. erfolgen kann. Durch diese Prüfung auf Fehlerfreiheit der empfangenen Datenpakete DP wird ein sogenannter Blackchannel zwischen den Sicherheitskomponenten 11, 12, 13 aufgebaut.

Sind in einem aktuellen Zyklus alle Funktionstests T einer Sicherheitskomponente 11, 12, 13 erfolgreich, so wird der Bereitschaftsstatus r dieser Sicherheitskomponente 11,12,13 auf aktiv gesetzt, sofern er nicht schon aktiv ist. Waren das Sicherheitsmodul M und der Bereitschaftsstatus r bereits auf aktiv gesetzt, so bleibt das Sicherheitsmodul M aktiviert - sofern nicht eine andere Sicherheitsvorkehrung das Sicherheitsmodul M deaktiviert. In Fig. 2 ist an den einer Sicherheitskomponenten 11, 12, 13 lediglich der essentielle Funktionstest T(DP1), T(DP2), T(DP3) einer Prüfung eines zyklischen fehlerfreien Empfangs eines Datenpakets DP vorgesehen. Schlägt dieser Funktionstest T(DP1), T(DP2), T(DP3) fehl, so wird der jeweilige Bereitschaftsstatus r auf inaktiv gesetzt, ist der Funktionstest T(DP1), T(DP2), T(DP3) erfolgreich - was hier dazu führt, dass "alle" Funktionstests T pro Sicherheitskomponente 11, 12, 13 erfolgreich sind, weil dies der einzige vorgesehene Funktionstest T ist - so wird der jeweilige Bereitschaftsstatus r auf aktiv gesetzt.

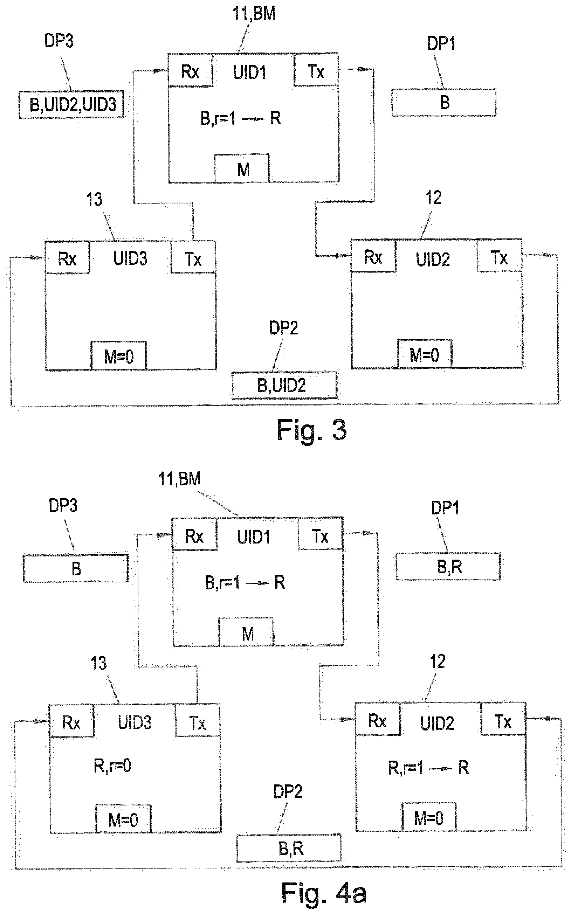

Es wird zudem erfindungsgemäß eine der Sicherheitskomponenten 11, 12, 13 als Busmaster BM ausgewählt, wobei die Auswahl des Busmasters BM anhand einer Komponentenidentifikation, z.B. einer Identifikationsnummer UID, der Sicherheitskomponenten 11, 12, 13 erfolgen kann. Beispielsweise kann jene Sicherheitskomponente 11, 12, 13 mit der geringsten Identifikationsnummer UID ausgewählt werden. In Fig. 3 wird beispielhaft die erste Sicherheitskomponente 11 mit der UID1 als Busmaster BM ausgewählt. Der Busmaster BM prüft erfindungsgemäß, ob die Sicherheitskomponenten 11, 12, 13 tatsächlich eine ringförmige Prüfanordnung, d.h. einen Ringbus, bilden. Hierzu sendet der Busmaster BM ein Busüberprüfungssignal B in einem Datenpaket DP1 an die nächste in Übertragungsrichtung vorgesehene Sicherheitskomponente, hier also die zweite Sicherheitskomponente 12. Sofern eine Verbindung zwischen den Sicherheitskomponenten 11, 12, 13 beseht, wird das Busüberprüfungssignal B wird von allen im Ringbus vorhandenen Sicherheitskomponenten 11, 12, 13 über den Signaleingang Rx in einem Datenpaket DP1, DP2, DP3 empfangen und über den Signalausgang Tx weitergeleitet.

Da somit jede Sicherheitskomponente 11, 12, 13 ein periodisches Datenpaket DP1, DP2, DP3 (mit einem Busüberprüfungssignal B) erwartet, kann als (essentieller) Funktionstest T die Prüfung eines zyklischen fehlerfreien Empfangs dieses Datenpakets DP durchgeführt werden. Erfolgt der Empfang des Datenpakets DP1, DP2, DP3 nicht wie erwartet oder schlagen die Fehlerprüfung und damit der (essentielle) Funktionstest T fehl, so deaktiviert die jeweilige Sicherheitskomponente 11, 12, 13 ihren Bereitschaftsstatus r.

Optional kann die Sicherheitskomponente 11, 12, 13 in diesem Fall auch ein Notsignal N in einem Datenpaket DP1, DP2, DP3 absenden, welches von allen Sicherheitskomponenten 11, 12, 13 jeweils in einem Datenpaket DP1, DP2, DP3 weitergeleitet wird und wobei alle Sicherheitskomponenten 11, 12, 13, die das Notsignal empfangen ihr Sicherheitsmodul M deaktivieren, was einen weiteren Sicherheitsmechanismus darstellt.

In Fig. 3 sendet somit die erste Sicherheitskomponente 11 als Busmaster BM das Busüberprüfungssignal B über seinen Signalausgang Tx in einem Datenpaket DP1 an den Signaleingang Rx der zweiten Sicherheitskomponente 12. Die zweite Sicherheitskomponente 12 sendet das Busüberprüfungssignal B in einem Datenpaket DP2 über seinen Signalausgang Tx an den Signaleingang Rx der dritten Sicherheitskomponente 13 und die dritte Sicherheitskomponente 13 das Busüberprüfungssignal B weiter in einem Datenpaket DP3 über seinen Signalausgang Tx an den Signaleingang Rx der ersten Sicherheitskomponente 11, welche den Busmaster BM darstellt. Der Busmaster BM empfängt das Busüberprüfungssignal B natürlich nur, wenn der Ringbus geschlossen ist. Damit kann durch den Busmaster BM durch Empfang des Busüberprüfungssignals B, sichergestellt werden, dass der Ringbus geschlossen ist.

Die Sicherheitskomponenten 11, 12, 13 sind vorteilhafterweise so ausgestaltet, dass sie jeweils ihre Identifikationsnummer UID1, UID2, UID3 mit dem Busüberprüfungssignal B im Datenpaket übermitteln, wie ebenso in Fig. 3 dargestellt. Entsprechend kann der Busmaster BM ausgestaltet sein, die Sicherheitskomponenten 11, 12, 13 anhand der mit dem Busüberprüfungssignals B empfangenen Identifikationen UID1, UID2, UID3 zu identifizieren. Wie in Fig. 3 dargestellt wird, erhält also die zweite Sicherheitskomponente 12 das Busüberprüfungssignal B mit dem Datenpaket DP1 vom Busmaster BM, fügt ihre Identifikationsnummer UID1 hinzu und übermittelt das Datenpaket DP2 mit dem Busüberprüfungssignal B an die dritte Sicherheitskomponente 13. Diese wiederum fügt ihre Identifikationsnummer UID3 hinzu und übermittelt das Busüberprüfungssignal B in einem Datenpaket DP3 an die erste Sicherheitskomponente 11, welche den Busmaster BM darstellt. Der Busmaster BM erhält im Datenpaket DP mit dem Busüberprüfungssignal B nicht nur den Hinweis, dass der Ringbus geschlossen ist, sondern auch die Identifikationsnummern UID2, UID3 der anderen Sicherheitskomponenten 12, 13; seine eigene Identifikationsnummer UID1 kennt der Busmaster BM bereits. Damit sind dem Busmaster BM die Sicherheitskomponenten 11, 12, 13 in der Prüfanordnung über ihre Identifikationsnummern UID1, UID2, UID3 bekannt.

Die Sicherheitskomponenten 11, 12, 13 führen im weiteren Verlauf weiterhin permanent zyklisch Funktionstests T, jedoch zumindest den essentiellen Funktionstest T, durch (Prüfung eines zyklischen, fehlerfreien Empfangs von Datenpaketen DP1, DP2, DP3). Die Funktionstests T sind in den Fig. 3 bis 5 aus Übersichtlichkeitsgründen nicht dargestellt.

Ebenso führt der Busmaster BM durch Versand eines Busüberprüfungssignals B weiterhin eine Prüfung auf eine geschlossene ringförmige Prüfanordnung durch.

Der Busmaster BM könnte die jeweilige Identifikationsnummern UID2, UID3 nun ebenso wieder an die jeweilige Sicherheitskomponenten 12, 13 zurückschicken (nicht dargestellt). Damit kann durch jede Sicherheitskomponente 11, 12, 13 selbst geprüft werden ob der Ringbus auch tatsächlich geschlossen ist. Vorzugsweise sind die Sicherheitskomponenten 12, 13 derart konfiguriert sein können, dass sie ihren Bereitschaftsstatus r auf inaktiv setzen, wenn sie ihre Identifikationsnummer UID2, UID3 nicht vom Busmaster BM zurückerhalten, da dies auf einen Fehler im Ringbus schließen lässt.

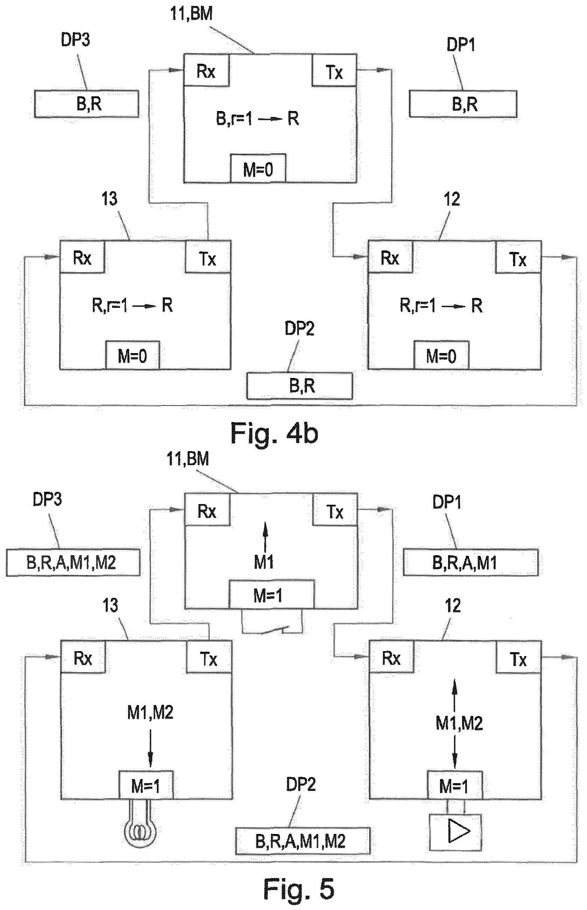

Erhält der Busmaster BM das Busüberprüfungssignal B über seinen Signaleingang Rx (womit ein geschlossener Ringbus festgestellt wird) und ist der Bereitschaftsstatus r des Busmasters BM aktiv, so übermittelt der Busmaster BM über seinen Signalausgang Tx ein Bereitschaftssignal R im Datenpaket DP an die weitere in Übertragungsrichtung vorgesehene (hier die zweite) Sicherheitskomponente 12, wie es in Fig. 4a, b dargestellt ist. Jede Sicherheitskomponente 11, 12, 13 überprüft bei Erhalt eines Datenpakets DP1, DP2, DP3 mit einem Bereitschaftssignal R ob ihr Bereitschaftsstatus r aktiv ist. Ist der Bereitschaftsstatus r inaktiv, so sendet die jeweilige Sicherheitskomponente 11, 12, 13 im Datenpaket DP1, DP2, DP3 kein Bereitschaftssignal R ab. Erhält eine Sicherheitskomponente 11, 12, 13 jedoch ein Bereitschaftssignal R im Datenpaket DP und ist ihr Bereitschaftsstatus r aktiv, so übermittelt die Sicherheitskomponente 11, 12, 13 über ihren Signalausgang Tx in einem Datenpaket ebenso ein Bereitschaftssignal R an den Signaleingang Rx der damit verbundenen Sicherheitskomponente 11, 12, 13.

In Fig. 4a ist angenommen, dass die dritte Sicherheitskomponente 13 einen inaktiven Bereitschaftsstatus r aufweist. Somit wird das Bereitschaftssignal R in einem Datenpaket DP1 vom Busmaster BM bis zur zweiten Sicherheitskomponente 12 geleitet. Da die zweite Sicherheitskomponente 12 einen aktiven Bereitschaftsstatus r aufweist, leitet sie das Bereitschaftssignal R in einem Datenpaket DP2 an die dritte Sicherheitskomponente 13 weiter. Die dritte Sicherheitskomponente 13 weist jedoch einen inaktiven Bereitschaftsstatus r auf und leitet daher das Bereitschaftssignal R nicht im Datenpaket DP3 an die erste Sicherheitskomponente 11 (hier als Busmaster BM) weiter. Somit schließt der Busmaster BM darauf, dass nicht alle Sicherheitskomponenten einen aktiven Bereitschaftsstatus r=1 haben.

Empfängt der Busmaster BM das Bereitschaftssignal R nicht, so sendet er vorteilhafterweise ein Notaussignal N in einem Datenpaket DP1 ab (nicht dargestellt), welches von den Sicherheitskomponenten 11, 12, 13 weitergeleitet wird. Die Sicherheitskomponenten 11, 12, 13 schalten bei Empfang des Notaussignals N ihr Sicherheitsmodul M inaktiv, sofern es nicht bereits inaktiv ist. Dies bietet eine zusätzliche Sicherheitsvorkehrung und stellt sicher, dass alle Sicherheitsmodule M inaktiv sind.

In Fig. 4b ist hingegen angenommen, dass alle Sicherheitskomponenten 11, 12, 13 einen aktiven Bereitschaftsstatus r aufweisen. Somit wird das Bereitschaftssignal R erst im Datenpaket DP1 zur zweiten Sicherheitskomponente 12 geleitet, welche aufgrund ihres aktiven Bereitschaftsstatus r das Bereitschaftssignal R im Datenpaket DP3 zur dritten Sicherheitskomponente 13 leitet. Die dritte Sicherheitskomponente 13 leitet aufgrund ihres aktiven Bereitschaftsstatus r das Bereitschaftssignal R im Datenpaket DP3 zur ersten Sicherheitskomponente 11, welche den Busmaster BM darstellt. Der Busmaster BM stellt damit fest, dass alle Sicherheitskomponenten 11, 12, 13 einen aktiven Bereitschaftsstatus r aufweisen und detektiert somit eine betriebsbereite Prüfanordnung. Es sei darauf hingewiesen, dass sowohl bei einem aktiven Bereitschaftsstaus r (Fig. 4b), als auch bei einem inaktiven Bereitschaftsstatus r (Fig. 4a) der dritten Sicherheitskomponente 13 der Busmaster BM das Busüberprüfungssignal B im Datenpaket DP3 erhält. Das bedeutet, dass in beiden Fällen eine geschlossene ringförmige Prüfanordnung vorhanden ist. Wäre dem nicht so, dann würde der Busmaster BM gar kein Datenpaket DP3 und damit kein Busüberprüfungssignal B (und natürlich kein Bereitschaftssignal R, etc.) erhalten.

Fig. 5 zeigt den Fall, dass der Busmaster BM bereits durch Empfang des Bereitschaftssignals R eine betriebsbereite Prüfanordnung festgestellt hat. Daher sendet der Busmaster BM ein Aktiviersignal A an alle weiteren Sicherheitskomponenten 12 13, d.h. erst in einem Datenpaket DP1 an die nächste in Übertragungsrichtung verbundene Sicherheitskomponente (hier die zweite Sicherheitskomponente 12) welches wiederum das Aktiviersignal A in einem Datenpaket2 an die wiederum nächste in Übertragungsrichtung verbundenen Sicherheitskomponente (hier die dritte Sicherheitskomponente 13) weiterleitet, etc. Die weiteren Sicherheitskomponenten 12, 13 schalten jeweils bei Empfang des Aktiviersignals A im Datenpaket DP ihr Sicherheitsmodul M auf aktiv, womit die ringförmige Prüfanordnung aktiv ist.

Nur wenn das Sicherheitsmodul M jeweils aktiv ist, ist es den Sicherheitskomponenten 11, 12, 13 erlaubt sicherheitsrelevante Informationen M1, M2, M3 zu versenden und empfangen.

In Fig. 5 ist angenommen, dass bereits alle Sicherheitskomponenten 11, 12, 13 ein Aktiviersignal A erhalten haben - weiterhin zyklisch erhalten.

Die erste Sicherheitskomponente 11 umfasst eine Eingabeeinheit, beispielsweise einen Schalter und kann aufgrund eines aktivierten Sicherheitsmoduls M dem Datenpaket DP1 sicherheitsrelevante Information M1 hinzufügen. So kann durch die erste Sicherheitskomponente 11 beispielsweise als sicherheitsrelevante Information M1 ein Messstartbefehl angewiesen werden.

Die zweite Sicherheitskomponente 12 umfasst eine Leistungseinheit. Da ihr Sicherheitsmodul M aktiviert ist, kann die zweite Sicherheitskomponente 12 somit sicherheitsrelevante Information M1 aus dem Datenpaket DP1 auslesen, als dem Datenpaket DP2 auch sicherheitsrelevante Information M2 hinzufügen. So kann die zweite Sicherheitskomponente 12 beispielsweise aus der von der ersten Sicherheitskomponente 11 stammende sicherheitsrelevanten Information M1 in Form eines Messstartbefehl ihre Leistungseinheit aktivieren und weiters dem Datenpaket DP2 sicherheitsrelevanten Information M2 in Form von Messwerten hinzufügen.

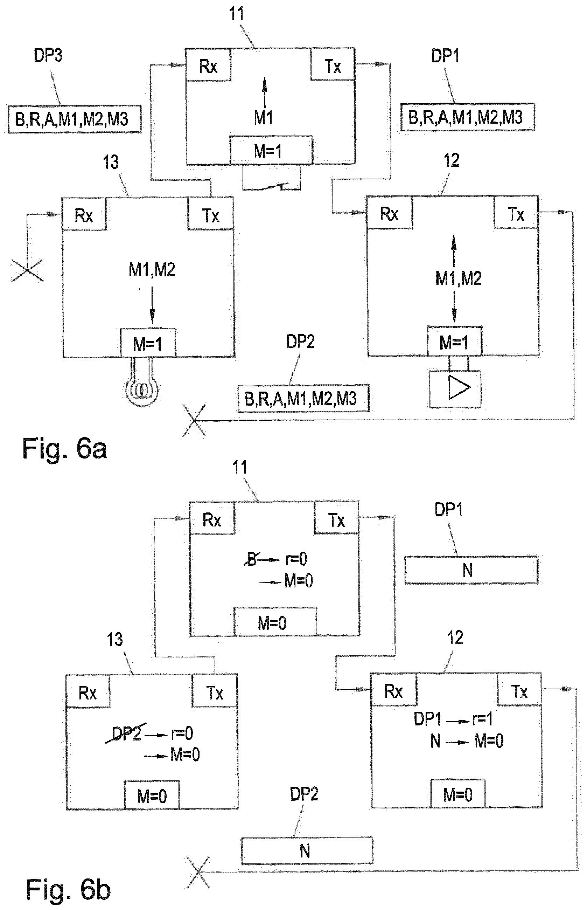

Die dritte Sicherheitskomponente 13 umfasst eine Ausgabeeinheit, welche nunmehr im Datenpaket DP2 enthaltene sicherheitsrelevante Information M1, M2 ausgeben kann, beispielsweise von der ersten Sicherheitskomponente 11 stammende sicherheitsrelevante Information M1 bezüglich der Eingabeeinheit, z.B. einen Messstartbefehl, oder von der zweiten Sicherheitskomponente 12 stammende sicherheitsrelevante Information M2 bezüglich der Leistungseinheit, z.B. einen Messwert. Die Sicherheitskomponenten 11, 12, 13 können also bei aktiviertem Sicherheitsmodul M jeweils einem Datenpaket DP1, DP2, DP3 sicherheitsrelevante Information M1, M2, M3 hinzufügen und/oder aus einem Datenpaket DP1, DP2, DP3 auslesen -je nach Ausgestaltung der Sicherheitskomponente 11, 12, 13. Die Eingabeeinheit, Leistungseinheit und Ausgabeeinheit sind nur in Fig. 5 und 6a dargestellt, da nur hier die Sicherheitsmodule M der Sicherheitskomponenten 11, 12, 13 aktiviert sind.

Die Datenpakete DP1, DP2, DP3 enthalten in Fig. 5 wie schon in Fig. 4 weiterein das Busüberprüfungssignal B und das Bereitschaftssignal R, wobei der Busmaster BM weiterhin eine geschlossene ringförmige Prüfanordnung überwacht, wie auch einen aktiven Bereitschaftsstatus r aller Sicherheitskomponenten 11, 12, 13.

Die Sicherheitskomponenten 11, 12, 13 können zudem einen Sicherheitstest S durchführen (nicht dargestellt) und bei Fehlschlagen des Sicherheitstest ihr Sicherheitsmodul M deaktivieren und ein Notaussignal N in einem Datenpaket DP1, DP2, DP3 an die weiteren in der Prüfanordnung angeordneten Sicherheitskomponenten 11, 12, 13 abgeben, welche bei Erhalt des Notaussignals N dieses nicht nur in einem Datenpaket DP1, DP2, DP3 weiterleiten, sondern auch ihr Sicherheitsmodul M deaktivieren. Ein fehlgeschlagener Sicherheitstest S führt also sofort zu einem Versand eines Datenpakets DP1, DP2, DP3 mit einem Notaussignal N, um die Sicherheitsmodule M aller Sicherheitskomponenten 11, 12, 13 zu deaktivieren. Ein Versand eines Notaussignals N kann auch durch den Busmaster BM erfolgen, falls der Busmaster BM sein versendetes Aktiviersignal A nicht am Signaleingang Rx in einem Datenpaket DP3 zurückerhält.

Im Gegensatz zu einem Sicherheitstest S, führt ein Fehlschlagen eines Funktionstests T (welcher nicht sicherheitskritisch ist) lediglich zu einem inaktiven Bereitschaftsstatus r der besagten Sicherheitskomponente 11, 12, 13. Dieser inaktive Bereitschaftsstatus r wird erst vom Busmaster BM erkannt, wenn er ein Bereitschaftssignal R versendet und nicht empfängt. Dabei können die weiteren Sicherheitskomponenten 11, 12, 13, deren Funktionstests T fehlschlagen, im aktiven Bereitschaftsstatus r verbleiben.

In Fig. 6a, b ist ein Ringbruch, d.h. eine Unterbrechung der Kommunikationsleitung, zwischen der zweiten Sicherheitskomponente 12 und der dritten Sicherheitskomponente 13 dargestellt. Es sei angenommen, dass der Ringbruch in Fig. 6a nach Empfang des Datenpakets DP3 durch den Busmaster BM entsteht, womit der Busmaster BM bei Absenden des Datenpakets DP1 noch keinen Hinweis auf den Ringbruch hat. Das Datenpaket DP1 mit dem Busüberprüfungssignal B (und hier auch einem Bereitschaftssignal R, Aktiviersignal A und sicherheitsrelevanten Informationen M1, M2, M3) gelangt somit zur zweiten Sicherheitskomponente 12, welche zu diesem Zeitpunkt ebenso noch keinen Ringbruch feststellt und somit ein Datenpaket DP2 abschickt, welches aber nicht bei der dritten Sicherheitskomponente 13 ankommt.

Die dritte Sicherheitskomponente 13 ist hier derart konfiguriert, dass sie kein Datenpaket DP3 sendet, wenn sie kein Datenpaket DP2 empfängt. Somit schlägt der zyklische Funktionstest T des Busmasters BM fehl und der Busmaster BM würde seinen Bereitschaftsstatus r deaktivieren. Der Busmaster BM setzt also seinen Bereitschaftsstatus r auf inaktiv und sendet ein Datenpaket DP mit einem Notaussignal N, um die Sicherheitsmodule M aller Sicherheitskomponenten 11, 12, 13 zu deaktivieren. Das Notsignal N gelangt im Datenpaket DP1 zur zweiten Sicherheitskomponente 12, womit das Sicherheitsmodul M der zweiten Sicherheitskomponente 12 deaktiviert wird.

Wäre die dritte Sicherheitskomponente 13 derart konfiguriert, dass sie auch ein Datenpaket DP3 sendet, wenn sie kein Datenpaket DP2 empfängt (nicht dargestellt), so würde zwar der essentielle Funktionstest T des Busmasters BM erfolgreich sein, womit der Busmaster BM seinen Bereitschaftsstatus r aktiv lässt. In diesem Fall ist es vorteilhaft, wenn der Busmaster BM derart konfiguriert ist, dass er ein Notaussignal N absendet, wenn er kein Busüberprüfungssignal B erhält. Der Busmaster BM würde aufgrund des Ringbruchs jedoch dennoch kein Busüberprüfungssignal B erhalten und somit ein Notaussignal N im Datenpaket DP1 absenden, wenn er derart konfiguriert ist. Der Busmaster BM erhält somit bei einem Ringbruch in jedem Fall kein Busüberprüfungssignal B und stellt damit eine nicht mehr geschlossene ringförmige Prüfanordnung fest (Fig. 6b).

Die zweite Sicherheitskomponente 12 kann das Notsignal N jedoch aufgrund des Ringbruchs nicht im Datenpaket DP2 an die dritte Sicherheitskomponente 13 übermitteln. Die dritte Sicherheitskomponente 13 führt jedoch zyklisch zumindest einen essentiellen Funktionstest T(DP) durch und wartet zumindest auf ein Datenpaket DP2 zur Überprüfung. Somit schlägt dieser Funktionstest T fehl, womit das dritte Sicherheitsmodul 13 seinen Betriebsstatus r auf inaktiv schaltet, womit auch das Sicherheitsmodul M auf inaktiv geschaltet wird.

Somit verbleiben in der dargestellten Prüfanordnung die erste und dritte Sicherheitskomponenten 11, 12, 13 mit inaktivem Sicherheitsmodul M. Die zweite Sicherheitskomponente 12 kann, sofern keine zugehörigen Funktionstests T fehlschlagen, einen aktiven Bereitschaftsstatus r aufweisen. Dies ist jedoch nur möglich, wenn die erste Sicherheitskomponente 11 derart konfiguriert ist, dass sie ein Datenpaket DP absendet, auch wenn sie kein Datenpaket DP (z.B. mit einem Busüberprüfungssignal B) erhält, da ansonsten der essentielle Funktionstest T der zweiten Sicherheitskomponente 12 fehlschlagen würde.

Die Prüfanordnung kann nun beispielsweise in einfacher Weise durch weitere Sicherheitskomponenten zwischen der zweiten Sicherheitskomponente 12 und der dritten Sicherheitskomponente 13 ergänzt werden. Alternativ kann auch eine andere Anordnung von Sicherheitskomponenten 11, 12, 13 vorgenommen werden oder schlicht der Ringbruch geschlossen werden.

Erst wenn der der Ringbruch behoben ist, wird wie oben beschrieben ein Busmaster BM bestimmt, ein Datenpaket DP1, DP2, DP3 mit einem Busüberprüfungssignal B zum Erkennen einer geschlossenen ringförmige Prüfanordnung abgesendet, ein Datenpaket DP1, DP2, DP3 mit einem Bereitschaftssignal R abgesendet und sofern alle Sicherheitskomponenten 11, 12, 13 einen aktiven Bereitschaftsstatus r aufweisen, ein Aktiviersignal A zum Aktivieren der Sicherheitsmodule M der Sicherheitskomponenten 11, 12, 13 der Prüfanordnung abgesendet. Daraufhin kann wieder sicherheitsrelevante Information M1, M2, M3 zwischen den Sicherheitskomponenten 11, 12, 13 ausgetauscht werden.

## Patentansprüche

1. Verfahren zum Betrieb einer Prüfanordnung umfassend eine Mehrzahl (n) Sicherheitskomponenten (11, 12, 13), wobei die Sicherheitskomponenten (11, 12, 13) jeweils einen Signaleingang (Rx) zum Empfang von Datenpaketen (DP1, DP2, DP3) und einen Signalausgang (Tx) zum Versand von Datenpaketen (DP1, DP2, DP3) aufweisen, wobei an den Sicherheitskomponenten (11, 12, 13) jeweils ein aktiv oder inaktiv setzbares Sicherheitsmodul (M) und ein aktiv oder inaktiv setzbarer Bereitschaftsstatus (r) vorgesehen ist, wobei das Sicherheitsmodul (M) einer Sicherheitskomponente (11, 12, 13) bei inaktivem Bereitschaftsstatus (r) der zugehörigen Sicherheitskomponente (11, 12, 13) inaktiv gesetzt wird, **dadurch gekennzeichnet, dass** die Signaleingänge (Rx) und Signalausgänge (Tx) der Sicherheitskomponenten (11, 12, 13) derart verbunden werden, dass die Sicherheitskomponenten (11, 12, 13) eine ringförmige Prüfanordnung mit einer Übertragungsrichtung für die Datenpakete (DP1, DP2, DP3) bilden, **dass** die Sicherheitskomponenten (11, 12, 13) jeweils zyklisch eine Anzahl an Funktionstest (T) durchführen, und ihren Bereitschaftsstatus (r) bei Erfolg der Anzahl an Funktionstests (T) auf aktiv und bei Fehlschlagen zumindest eines der Funktionstests (T) auf inaktiv setzen, wobei als einer der Funktionstests (T) ein zyklischer fehlerfreier Empfang eines Datenpakets (DP) geprüft wird, **und dass** eine der Sicherheitskomponenten (1, 11, 12, 13) als Busmaster (BM) ausgewählt wird, welcher zyklisch ein Busüberprüfungssignal (B) in einem Datenpaket (DP1) an die nächste in Übertragungsrichtung vorgesehene Sicherheitskomponente (11, 12, 13) sendet, wobei das Busüberprüfungssignal (B) jeweils von den Sicherheitskomponenten (11, 12, 13) in einem Datenpaket (DP2, DP3) weitergeleitet wird, **und dass** der Busmaster (BM) bei einem Empfang des Busüberprüfungssignals (B) in einem Datenpaket (DP3) eine geschlossene ringförmige Prüfanordnung feststellt.

2. Verfahren nach Anspruch 1, **dadurch gekennzeichnet, dass** der Busmaster (BM) bei Feststellung einer geschlossenen ringförmigen Prüfanordnung zyklisch prüft, ob sein Bereitschaftsstatus (r) aktiv ist und bei einem aktiven Bereitschaftsstatus (r) ein Bereitschaftssignal (R) in einem Datenpaket (DP1) an die nächste in Übertragungsrichtung befindliche Sicherheitskomponente (11, 12, 13) sendet, **und dass** die Sicherheitskomponenten (11, 12, 13) jeweils bei Empfang des Bereitschaftssignals (R) prüfen ob ihr Bereitschaftsstatus (r) aktiv ist und bei einem aktivem Bereitschaftsstatus (r) ein Bereitschaftssignal (R) in einem Datenpaket (DP2, DP3) an die nächste in Übertragungsrichtung vorgesehene Sicherheitskomponente (11, 12, 13) senden.

3. Verfahren nach Anspruch 2, **dadurch gekennzeichnet, dass** der Busmaster (BM) bei Empfang des Bereitschaftssignals (R) eine betriebsbereite Prüfanordnung feststellt und ein Aktiviersignal (A) in einem Datenpaket (DP1) an die nächste in Übertragungsrichtung vorgesehene Sicherheitskomponente (11, 12, 13) sendet, wobei die Sicherheitskomponenten (11, 12, 13) jeweils bei Empfang eines Aktiviersignals (A) ihr Sicherheitsmodul (M) aktivieren und das Aktiviersignal (A) in einem Datenpaket (DP2, DP3) weiterleiteten.

4. Verfahren nach Anspruch 3, **dadurch gekennzeichnet, dass** der Busmaster (BM) nach dem Versand eines Bereitschaftssignals (R) und bei Nicht-Empfang eines Bereitschaftssignals (R) ein Notaussignal (N) in einem Datenpaket (DP1) an die nächste in Übertragungsrichtung vorgesehene Sicherheitskomponente (11, 12, 13) sendet, wobei die Sicherheitskomponenten (11, 12, 13) jeweils bei Empfang des Notaussignals (N) ihr Sicherheitsmodul (M) deaktivieren und das Notaussignal (N) in einem Datenpaket (DP2, DP3) weiterleiten.

5. Verfahren nach einem der Ansprüche 1 bis 3, **dadurch gekennzeichnet, dass** der Busmaster (BM) nach dem Versand eines Busüberprüfungssignals (B) und bei Nicht-Empfang eines Busüberprüfungssignals (B) ein Notaussignal (N) in einem Datenpaket (DP1) an die nächste in Übertragungsrichtung vorgesehene Sicherheitskomponente (11, 12, 13) sendet, wobei die Sicherheitskomponenten (11, 12, 13) jeweils bei Empfang des Notaussignals (N) ihr Sicherheitsmodul (M) deaktivieren und das Notaussignal (N) in einem Datenpaket (DP2, DP3) weiterleiten.

6. Verfahren nach einem der Ansprüche 1 bis 5, **dadurch gekennzeichnet, dass** die Sicherheitskomponenten (11, 12, 13) einen Sicherheitstest (S) durchführen und bei Fehlschlagen des Sicherheitstests (S) die jeweilige Sicherheitskomponente (11, 12, 13) ihren Bereitschaftsstatus (r) deaktiviert und ein Notaussignal (N) in einem Datenpaket (DP1, DP2, DP3) an die nächste in Übertragungsrichtung vorgesehene Sicherheitskomponente (11, 12, 13) senden, wobei die Sicherheitskomponenten (11, 12, 13) bei Empfang des Notaussignals (N) ihr Sicherheitsmodul (M) deaktivieren und das Notaussignal (N) in einem Datenpaket (DP1, DP2, DP3) versenden.

7. Verfahren nach einem der Ansprüche 1 bis 6, **dadurch gekennzeichnet, dass** die Auswahl des Busmasters (BM) über eine Komponentenidentifikation (UID1, UID2, UID3) der Sicherheitskomponenten (11, 12, 13) erfolgt, vorzugsweise die Sicherheitskomponente (11, 12, 13) mit der niedrigsten Komponentenidentifikationen (UID1, UID2, UID3) als Busmaster (BM) ausgewählt wird.

8. Verfahren nach einem der Ansprüche 1 bis 7, **dadurch gekennzeichnet, dass** die Sicherheitskomponenten (11, 12, 13) eine Komponentenidentifikation (UID1, UID2, UID3) mit dem Busüberprüfungssignal (B) im Datenpaket (DP1, DP2, DP3) senden, **und dass** der Busmaster (BM) die Sicherheitskomponenten (11, 12, 13) durch die mit dem Busüberprüfungssignal (B) empfangenen Komponentenidentifikationen (UID1, UID2, UID3) identifiziert.

9. Verfahren nach Anspruch 8, **dadurch gekennzeichnet, dass** der Busmaster (BM) die Komponentenidentifikationen (UID1, UID2, UID3) in einem Datenpaket (DP1) wieder an die jeweilige Sicherheitskomponenten (11, 12, 13) zurück sendet und eine Sicherheitskomponente (11, 12, 13) ihren Bereitschaftsstatus (r) auf inaktiv setzt, wenn sie ihre Identifikation (UID1, UID2, UID3) nicht vom Busmaster (BM) zurück empfängt.

## Claims

1. A method for operating a test arrangement comprising a plurality (n) of safety components (11, 12, 13), wherein the safety components (11, 12, 13) each have a signal input (Rx) for receiving data packets (DP1, DP2, DP3) and a signal output (Tx) for transmitting data packets (DP1, DP2, DP3), wherein each of the safety components (11, 12, 13) has a safety module (M) that can be set to active or inactive, and a ready status (r) that can be set to active or inactive, wherein the safety module (M) of a safety component (11, 12, 13) is set to inactive when the associated safety component (11, 12, 13) has an inactive ready status (r), **characterized in that** the signal inputs (Rx) and signal outputs (Tx) of the safety components (11, 12, 13) are connected in such a way that the safety components (11, 12, 13) form a circular test arrangement with a direction of transmission for the data packets (DP1, DP2, DP3), **in that** the safety components (11, 12, 13) each cyclically carry out a number of function tests (T), and set their ready status (r) to active if the number of function tests (T) is successful and to inactive if at least one of the function tests (T) fails, wherein one of the function tests (T) is checking for a cyclic, error-free reception of a data packet (DP), **and in that** one of the safety components (1, 11, 12, 13) is selected as the bus master (BM), which cyclically transmits a bus verification signal (B) in a data packet (DP1) to the adjacent safety component (11, 12, 13) in the direction of transmission, wherein the bus verification signal (B) is forwarded in each case by the safety components (11, 12, 13) in a data packet (DP2, DP3), **and in that** the bus master (BM), upon receipt of the bus verification signal (B) in a data packet (DP3), determines that the circular test arrangement is closed.

2. The method according to claim 1, **characterized in that** the bus master (BM), upon determining that the circular test arrangement is closed, cyclically checks whether its ready status (r) is active and, if the ready status (r) is active, transmits a ready signal (R) in a data packet (DP1) to the adjacent safety component (11, 12, 13) in the direction of transmission, **and in that** the safety components (11, 12, 13), upon receipt of the ready signal (R), each check whether their ready status (r) is active, and, if the ready status (r) is active, transmit a ready signal (R) in a data packet (DP2, DP3) to the adjacent safety component (11, 12, 13) in the direction of transmission.

3. The method according to claim 2, **characterized in that** the bus master (BM), upon receipt of the ready signal (R), determines that the test arrangement is operational, and transmits an activation signal (A) in a data packet (DP1) to the adjacent safety component (11, 12, 13) in the direction of transmission, wherein the safety components (11, 12, 13), upon receipt of an activation signal (A), each activate their safety module (M), and forward the activation signal (A) in a data packet (DP2, DP3).

4. The method according to claim 3, **characterized in that** the bus master (BM), after transmitting a ready signal (R) and not receiving a ready signal (R), transmits an emergency stop signal (N) in a data packet (DP1) to the adjacent safety component (11, 12, 13) in the direction of transmission, wherein the safety components (11, 12, 13) each deactivate their safety module (M) upon receipt of the emergency stop signal (N), and forward the emergency stop signal (N) in a data packet (DP2, DP3).

5. The method according to any of claims 1 to 3, **characterized in that** the bus master (BM), after transmitting a bus verification signal (B) and not receiving a bus verification signal (B), transmits an emergency stop signal (N) in a data packet (DP1) to the adjacent safety component (11, 12, 13) in the direction of transmission, wherein the safety components (11, 12, 13) each deactivate their safety module (M) upon receipt of the emergency stop signal (N), and forward the emergency stop signal (N) in a data packet (DP2, DP3).

6. The method according to any of claims 1 to 5, **characterized in that** the safety components (11, 12, 13) carry out a safety test (S), and if the safety test (S) fails, the respective safety components (11, 12, 13) deactivate their ready status (r), and transmit an emergency stop signal (N) in a data packet (DP1, DP2, DP3) to the adjacent safety component (11, 12, 13) in the direction of transmission, wherein the safety components (11, 12, 13) deactivate their safety module (M) upon receipt of the emergency stop signal (N), and transmit the emergency stop signal (N) in a data packet (DP1, DP2, DP3).

7. The method according to any of claims 1 to 6, **characterized in that** the bus master (BM) is selected via a component identification (UID1, UID2, UID3) of the safety components (11, 12, 13), and preferably the safety component (11, 12, 13) with the lowest component identification (UID1, UID2, UID3) is selected as the bus master (BM).

8. The method according to any of claims 1 to 7, **characterized in that** the safety components (11, 12, 13) transmit a component identification (UID1, UID2, UID3) with the bus verification signal (B) in the data packet (DP1, DP2, DP3), **and in that** the bus master (BM) identifies the safety components (11, 12, 13) by the component identifications (UID1, UID2, UID3) received with the bus verification signal (B).

9. The method according to claim 8, **characterized in that** the bus master (BM) transmits the component identifications (UID1, UID2, UID3) back to the respective safety components (11, 12, 13) in a data packet (DP1), and a safety component (11, 12, 13) sets its ready status (r) to inactive if it does not receive its identification (UID1, UID2, UID3) back from the bus master (BM).

## Revendications

1. Procédé permettant de faire fonctionner un agencement d'essai comprenant une pluralité (n) de composants de sécurité (11, 12, 13), les composants de sécurité (11, 12, 13) présentant respectivement une entrée de signal (Rx) pour la réception de paquets de données (DP1, DP2, DP3) et une sortie de signal (Tx) pour l'envoi de paquets de données (DP1, DP2, DP3), respectivement un module de sécurité (M) pouvant être réglé pour être actif ou inactif et un état de disponibilité (r) pouvant être réglé pour être actif ou inactif étant prévus au niveau des composants de sécurité (11, 12, 13), le module de sécurité (M) d'un composant de sécurité (11, 12, 13) étant réglé pour être inactif lorsque l'état de disponibilité (r) du composant de sécurité (11, 12, 13) associé est inactif, **caractérisé en ce que** les entrées de signaux (Rx) et les sorties de signaux (Tx) des composants de sécurité (11, 12, 13) sont connectées de telle sorte que les composants de sécurité (11, 12, 13) forment un agencent d'essai annulaire comportant un sens de transmission pour les paquets de données (DP1, DP2, DP3), **en ce que** les composants de sécurité (11, 12, 13) effectuent respectivement de manière cyclique un certain nombre de tests fonctionnels (T), et leur état de disponibilité (r) est réglé pour être actif en cas de succès du certain nombre de tests fonctionnels (T) et pour être inactif en cas d'échec d'au moins l'un des tests fonctionnels (T), une réception cyclique sans erreur d'un paquet de données (DP) étant vérifiée en tant que l'un des tests fonctionnels (T),
**et en ce que** l'un des composants de sécurité (1, 11, 12, 13) est sélectionné en tant que maître de bus (BM), lequel envoie de manière cyclique un signal de vérification de bus (B) dans un paquet de données (DP1) au prochain composant de sécurité (11, 12, 13) prévu dans le sens de transmission, le signal de vérification de bus (B) étant respectivement transmis par les composants de sécurité (11, 12, 13) dans un paquet de données (DP2, DP3), **et en ce que** le maître de bus (BM), lors de la réception du signal de vérification de bus (B) dans un paquet de données (DP3), détecte un agencement d'essai annulaire fermé.

2. Procédé selon la revendication 1, **caractérisé en ce que** le maître de bus (BM) vérifie de manière cyclique si son état de disponibilité (r) est actif lors de la détection d'un agencement d'essai annulaire fermé et, lorsqu'un état de disponibilité (r) est actif, envoie un signal de disponibilité (R) dans un paquet de données (DP1) au prochain composant de sécurité (11, 12, 13) dans le sens de transmission, **et en ce que** les composants de sécurité (11, 12, 13) vérifient, respectivement à la réception du signal de disponibilité (R), si leur état de disponibilité (r) est actif et, lorsqu'un état de disponibilité (r) est actif, envoient un signal de disponibilité (R) dans un paquet de données (DP2, DP3) au prochain composant de sécurité (11, 12, 13) prévu dans le sens de transmission.

3. Procédé selon la revendication 2, **caractérisé en ce que** le maître de bus (BM), lors de la réception du signal de disponibilité (R), détecte un agencement d'essai prêt à fonctionner et envoie un signal d'activation (A) dans un paquet de données (DP1) au prochain composant de sécurité (11, 12, 13) prévu dans le sens de transmission, les composants de sécurité (11, 12, 13) activant respectivement leur module de sécurité (M) lors de la réception d'un signal d'activation (A) et transmettant le signal d'activation (A) dans un paquet de données (DP2, DP3).

4. Procédé selon la revendication 3, **caractérisé en ce que** le maître de bus (BM), après l'envoi d'un signal de disponibilité (R) et en cas de non-réception d'un signal de disponibilité (R), envoie un signal d'arrêt d'urgence (N) dans un paquet de données (DP1) au prochain composant de sécurité (11, 12, 13) prévu dans le sens de transmission, les composants de sécurité (11, 12, 13) désactivant respectivement leur module de sécurité (M) à la réception du signal d'arrêt d'urgence (N) et transmettant le signal d'arrêt d'urgence (N) dans un paquet de données (DP2, DP3).

5. Procédé selon l'une des revendications 1 à 3, **caractérisé en ce que** le maître de bus (BM), après l'envoi d'un signal de vérification de bus (B) et en cas de non-réception d'un signal de vérification de bus (B), envoie un signal d'arrêt d'urgence (N) dans un paquet de données (DP1) au prochain composant de sécurité (11, 12, 13) prévu dans le sens de transmission, les composants de sécurité (11, 12, 13) désactivant respectivement leur module de sécurité (M) à la réception du signal d'arrêt d'urgence (N) et transmettant le signal d'arrêt d'urgence (N) dans un paquet de données (DP2, DP3).

6. Procédé selon l'une des revendications 1 à 5, **caractérisé en ce que** les composants de sécurité (11, 12, 13) effectuent un test de sécurité (S) et, en cas d'échec du test de sécurité (S), le composant de sécurité (11, 12, 13) respectif désactive son état de disponibilité (r) et envoie un signal d'arrêt d'urgence (N) dans un paquet de données (DP1, DP2, DP3) au prochain composant de sécurité (11, 12, 13) prévu dans le sens de transmission, les composants de sécurité (11, 12, 13) désactivant leur module de sécurité (M) lors de la réception du signal d'arrêt d'urgence (N) et envoyant le signal d'arrêt d'urgence (N) dans un paquet de données (DP1, DP2, DP3).

7. Procédé selon l'une des revendications 1 à 6, **caractérisé en ce que** la sélection du maître de bus (BM) s'effectue par l'intermédiaire d'une identification de composant (UID1, UID2, UID3) des composants de sécurité (11, 12, 13), de préférence le composant de sécurité (11, 12, 13) comportant les identifications de composant (UID1, UID2, UID3) les plus basses est sélectionné en tant que maître de bus (BM).

8. Procédé selon l'une des revendications 1 à 7, **caractérisé en ce que** les composants de sécurité (11, 12, 13) envoient une identification de composant (UID1, UID2, UID3) avec le signal de vérification de bus (B) dans le paquet de données (DP1, DP2, DP3), **et en ce que** le maître de bus (BM) identifie les composants de sécurité (11, 12, 13) au moyen des identifications de composant (UID1, UID2, UID3) reçues avec le signal de vérification de bus (B).

9. Procédé selon la revendication 8, **caractérisé en ce que** le maître de bus (BM) renvoie les identifications de composant (UID1, UID2, UID3) dans un paquet de données (DP1) aux composants de sécurité (11, 12, 13) respectifs et un composant de sécurité (11, 12, 13) règle son état de disponibilité (r) pour être inactif s'il ne reçoit pas à nouveau son identification (UID1, UID2, UID3) en provenance du maître de bus (BM).
